Europäisches Patentamt

European Patent Office

Office européen des brevets

(11) Numéro de publication : **0 449 723 A1**

(12) # DEMANDE DE BREVET EUROPEEN

(21) Numéro de dépôt : **91400810.7**

(51) Int. Cl.⁵ : **H03K 5/19**, H03K 3/023, F02P 7/06

(22) Date de dépôt : **26.03.91**

(30) Priorité : 27.03.90 FR 9003881

(43) Date de publication de la demande :
02.10.91 Bulletin 91/40

(84) Etats contractants désignés :
DE ES GB IT

(71) Demandeur : JAEGER
2, rue Baudin
F-92303 Levallois-Perret (FR)

(72) Inventeur : Hoareau, Eddie
3 allée Claude Debussy
F-93500 Pantin (FR)
Inventeur : Combalbert, Daniel
51-53 rue Voltaire
F-93120 La Courneuve (FR)

(74) Mandataire : Martin, Jean-Jacques et al
Cabinet REGIMBEAU 26, Avenue Kléber
F-75116 Paris (FR)

(54) Dispositif de mise en forme d'un signal impulsionnel de capteur.

(57) La présente invention concerne un dispositif de mise en forme d'un signal de capteur du type comprenant deux impulsions successives de polarités opposées, respectivement de première polarité, puis de deuxième polarité, caractérisé par le fait qu'il comprend : un premier étage (120) de type bascule de Schmitt connecté en sortie du capteur (C) et conçu pour passer d'un état de repos à un second état lors de l'arrivée d'une impulsion de première polarité générant ainsi un premier front d'un premier sens puis pour passer du second état à l'état de repos lors de l'arrivée d'une impulsion de deuxième polarité générant ainsi un second front d'un second sens, opposé au premier, et un second étage (140) de type monostable connecté en sortie du premier étage (120) et conçu pour être déclenché par les fronts de second sens issus du premier étage.

EP 0 449 723 A1

FIG_3

La présente invention concerne le domaine des dispositifs de mise en forme de signaux impulsionnels.

La présente invention s'applique tout particulièrement à la mise en forme de signaux impulsionnels générés par des capteurs équipant les véhicules automobiles.

Plus précisément, la présente invention a pour but de permettre la mise en forme d'un signal de capteur du type comprenant deux impulsions successives de polarité opposées, respectivement de première polarité, puis de deuxième polarité.

De tels signaux comprenant deux impulsions successives peuvent être générés par exemple par un capteur dit de type PMH, c'est-à-dire de détection de point mort haut. De tels capteurs sont formés généralement à l'aide d'un noyau de fer doux associé à une bobine parcourue par un courant continu et placé en regard d'un volant pourvu d'une encoche ou d'une denture en saillie, de sorte que la modulation du flux dans le noyau induite par la rotation du volant conduise à une force-contrélectromotrice aux bornes de la bobine.

Les capteurs générant un signal comprenant deux impulsions de polarités opposées peuvent également être formés par l'association d'un aimant et d'une bobine placés en regard du volant précité.

Ces capteurs sont bien connus de l'homme de l'art et ne seront pas décrits plus en détail par la suite.

Différents dispositifs de mise en forme de tels signaux impulsionnels ont déjà été proposés.

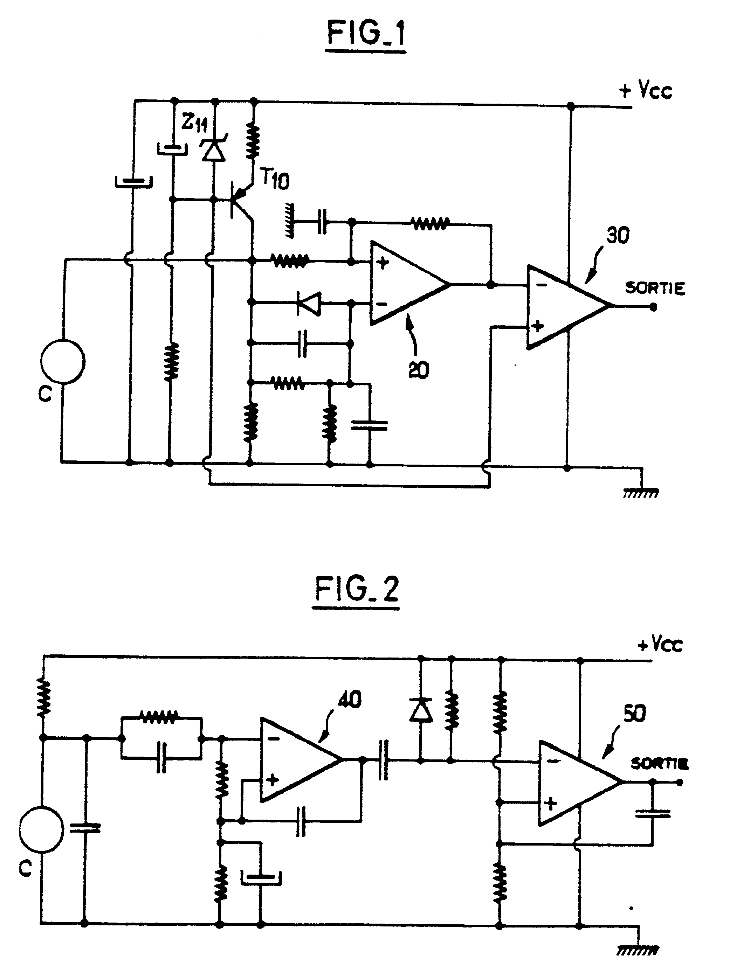

On a représenté sur la figure 1 annexée un premier mode de réalisation d'un circuit de mise en forme connu.

On aperçoit sur la figure 1 annexée un capteur C alimenté à courant constant par l'intermédiaire d'un transistor T10 régulé par une diode Zener Z11.

Le capteur C attaque un étage comparateur 20 qui lui-même commande un étage de sortie inverseur 30.

Les deux étages 20 et 30 sont organisés autour d'amplificateurs opérationnels.

Plus précisément l'étage de sortie inverseur 30 a son entrée inverseuse reliée à la sortie de l'étage comparateur 20, tandis qu'il reçoit sur son entrée non inverseuse la tension de référence définie par la diode Zener Z11.

Au repos l'étage comparateur 20 a sa sortie au niveau haut. L'étage de sortie 30 a par conséquent sa sortie au niveau bas.

Lorsque l'encoche du volant passe en regard du capteur C celui-ci génère une impulsion négative. L'étage comparateur 20 passe donc au niveau bas et l'étage de sortie 30 au niveau haut.

Dès la fin de l'impulsion négative l'étage comparateur 20 repasse au niveau haut et l'étage de sortie 30 passe simultanément au niveau bas.

Le circuit de mise en forme représenté sur la figure 1 permet ainsi une remise en forme correcte des signaux issus du capteur C. Cependant, ce circuit est très sensible aux parasites de polarité négative susceptibles d'apparaître sur le réseau d'alimentation électrique des véhicules automobiles, tels que les parasites qui apparaissent lors de la mise en service d'équipements gros consommateurs de courant, par exemple les équipements de dégivrage. En effet, de tels parasites négatifs induisent une impulsion au niveau de la sortie de l'étage 30.

Le circuit connu de mise en forme représenté sur la figure 2 annexée comprend un capteur C suivi de deux étages monostables 40, 50 montés en cascade.

Au repos la sortie du premier monostable 40 est au niveau bas. Il en est donc de même du deuxième monostable 50.

Lorsque l'encoche du volant passe en regard du capteur celui-ci génère d'abord une impulsion négative. Le premier monostable 40 passe au niveau haut. Il en est de même du deuxième monostable 50.

Le circuit revient à l'état de repos après achèvement de l'impulsion négative et la fin des temporisations définies par les étages monostables 40, 50.

Le circuit connu représenté sur la figure 2 présente le même inconvénient que le circuit précité représenté sur la figure 1 : il est très sensible aux impulsions négatives.

La présente invention a pour but de proposer un nouveau dispositif de mise en forme de signal électrique impulsionnel qui évite les inconvénients de la technique antérieure, c'est-à-dire qu'il ne puisse être déclenché lors de l'apparition de simples parasites de polarité négative.

Ce but est atteint selon la présente invention grâce à un dispositif de mise en forme d'un signal de capteur du type comprenant deux impulsions successives de polarités opposées, respectivement de première polarité, puis de deuxième polarité, caractérisé par le fait qu'il comprend :

   – un premier étage de type bascule de Schmitt connecté en sortie du capteur et conçu pour passer d'un état de repos à un second état lors de l'arrivée d'une impulsion de première polarité générant ainsi un premier front d'un premier sens puis pour passer du second état à l'état de repos lors de l'arrivée d'une impulsion de deuxième polarité générant ainsi un second front d'un second sens, opposé au premier, et

   – un second étage de type monostable connecté en sortie du premier étage et conçu pour être déclenché par les fronts de second sens issus du premier étage.

Ainsi selon la présente invention seule l'apparition successive d'une première impulsion d'une première polarité suivie d'une deuxième impulsion d'une deuxième polarité peut provoquer la génération d'une impulsion de sortie.

Le circuit de mise en forme conforme à la présente invention est par conséquent insensible aux parasites de polarité négative, voire aux parasites de polarité positive susceptibles d'apparaître sur le réseau d'alimentation électrique des véhicules automobiles.

D'autres caractéristiques, buts et avantages de la présente invention apparaîtront à la lecture de la description détaillée qui va suivre et en regard des dessins annexés, donnés à titre d'exemple non limitatif et sur lesquels :

- les figures 1 et 2 précédemment décrites représentent un état de la technique, et
- la figure 3 représente le schéma d'un circuit de mise en forme conforme à la présente invention.

Comme indiqué précédemment, le circuit de mise en forme proposé dans le cadre de la présente invention comprend essentiellement un capteur C suivi d'une bascule 120 de type bascule de Schmitt et d'un monostable 140.

Le capteur C est polarisé par un module 110 comprenant un transistor T113 associé à trois résistances R111, R112, R114.

Le module 110 est alimenté par la tension de bord +VCC du véhicule automobile issue de l'accumulateur. La résistance R111 est intercalée entre la borne d'alimentation positive +VCC et la base du transistor T113. La résistance R112 relie la même borne d'alimentation positive +VCC à l'émetteur du transistor T113. La résistance R114 relie la base du transistor T113 à la masse du montage. Le capteur C est relié entre le collecteur du transistor T113 et la masse.

Le capteur C peut être formé, comme indiqué précédemment, d'une bobine associée à un noyau de fer doux, ou d'une bobine associée à un aimant, de façon connue en soi, ou encore de tout capteur fonctionnellement équivalent.

De préférence, un filtre est connecté en parallèle du capteur C.

Selon le mode de réalisation représenté sur la figure 2 ce filtre comprend une résistance R116 connectée en parallèle d'un condensateur C115.

Une diode D121 est intercalée entre la sortie du capteur C, c'est-à-dire le point commun au capteur C et au collecteur de T113, et l'entrée de la bascule 120.

La bascule 120 comprend un amplificateur opérationnel OP128.

L'entrée inverseuse de OP128 est polarisée par un pont diviseur résistif comprenant deux résistances R122, R123 connectées en série.

Le point commun aux résistances R122, R123 est relié à l'entrée inverseuse de OP128. La seconde borne de la résistance R122 est reliée à la cathode de D121. L'anode de D121 est reliée au collecteur de T113. La deuxième borne de la résistance R123 est reliée à la masse. Un condensateur C124 est de préférence connecté en parallèle de R123.

L'entrée non inverseuse de OP128 est polarisée par un pont diviseur résistif comprenant deux résistances R125, R126 connectées en série.

Le point commun aux résistances R125, R126 est relié à l'entrée non inverseuse de OP128. La deuxième borne de la résistance R125 est reliée à la cathode de D121. La deuxième borne de R126 est reliée à la masse du montage. De préférence, un condensateur C127 est relié en parallèle de R126.

Une contre-réaction est prévue entre la sortie de OP128 et son entrée non inverseuse. En l'espèce cette contre-réaction est formée par la combinaison d'une résistance R129 connectée en parallèle d'un condensateur C130.

Les ponts diviseurs résistifs R122, R123 d'une part, R125, R126 d'autre part, sont calculés de telles sortes que, au repos, le potentiel sur l'entrée inverseuse de OP128 soit supérieur au potentiel sur l'entrée non inverseuse de OP128. Ainsi, au repos, la bascule 120 a sa sortie au niveau bas.

De préférence, les résistances R122, R125, sont de valeur identique, tandis que la résistance R123 a une valeur légèrement supérieure à la résistance R126.

Par ailleurs, le condensateur C127 a une valeur bien supérieure au condensateur C124, de sorte que le potentiel sur l'entrée inverseuse de OP128 évolue beaucoup plus rapidement que le potentiel sur son entrée non inverseuse.

Le monostable de sortie 140 comprend un amplificateur opérationnel OP146.

L'entrée inverseuse de OP146 est reliée à la sortie de OP128 par l'intermédiaire d'un condensateur C141. La même entrée inverseuse de OP146 est reliée à la borne d'alimentation positive +VCC par l'intermédiaire d'une résistance R143. De plus, une diode D142 est connectée en parallèle de la résistance R143. Cette diode D142 a sa cathode reliée à la borne d'alimentation positive +VCC, tandis que son anode est reliée à l'entrée inverseuse de OP146.

L'entrée non inverseuse de OP146 reçoit une tension de référence définie par un pont diviseur résistif formé par deux résistances R144, R145 connectées en série entre la borne d'alimentation positive +VCC et la masse. La résistance R144 est placée côté alimentation positive +VCC, tandis que la résistance R145 est placée côté masse. Ainsi, la sortie de l'amplificateur opérationnel OP146 est au niveau bas tant que le potentiel appliqué sur son entrée inverseuse est supérieure à la tension de référence définie par R144, R145. La sortie de OP146 passe au niveau haut lorsque le potentiel appliqué sur son entrée inverseuse devient inférieur à ladite tension de référence.

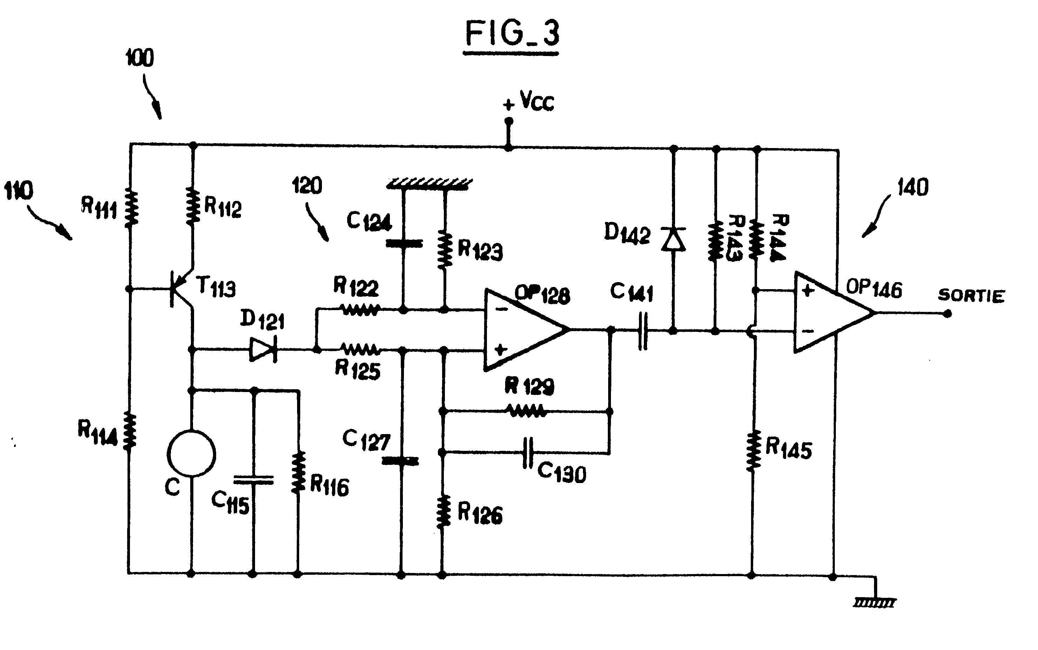

Le fonctionnement du circuit de mise en forme représenté sur la figure 3 annexée est pour l'essentiel le suivant.

Au repos la tension aux bornes du capteur C est une tension constante, égale à une fraction de la tension d'alimentation +VCC. Le potentiel appliqué sur l'entrée inverseuse de OP128 étant supérieur au potentiel appliqué sur son entrée non inverseuse, la sortie de OP128 est au niveau bas. La sortie de OP146 est également au niveau bas.

Lorsque l'encoche du volant passe en regard du capteur C, celui-ci va générer successivement une impulsion de polarité négative puis une impulsion de polarité positive.

Lors de l'apparition de l'impulsion de polarité négative aux bornes du capteur C, le potentiel sur l'entrée inverseuse de OP128 devient inférieur au potentiel sur son entrée non inverseuse. La bascule 120 est donc déclenchée. Sa sortie passe au niveau haut. Cependant ce basculement est sans effet sur le monostable de sortie 140 en raison de la présence de la diode D142. En raison de la contre-réaction sur OP128 définie par C130 et R129, le potentiel de repos défini sur l'entrée non inverseuse de OP128 devient légèrement supérieur au potentiel appliqué à son entrée inverseuse. On obtient ainsi un état stable. De ce fait, l'arrivée de la fin de l'impulsion négative est sans effet sur la bascule 120 et le monostable 140.

Par contre, lors de l'arrivée de l'impulsion positive en sortie du capteur C, le potentiel appliqué à l'entrée inverseuse de OP128 va redevenir supérieur au potentiel appliqué à son entrée non inverseuse. La sortie de OP128 repasse alors au niveau bas. Simultanément, le potentiel de l'entrée inverseuse de OP146 devient inférieure à la tension de référence appliquée sur son entrée non inverseuse: La sortie de OP146 passe ainsi au niveau haut.

Par la suite, le condensateur C141 se charge par l'intermédiaire de la résistance R143. Lorsque le potentiel sur l'entrée inverseuse de OP146 redevient supérieur à la tension de référence définie par les résistances R144, R145, l'amplificateur opérationnel a sa sortie qui repasse au niveau bas.

La durée de l'impulsion de sortie du monostable 140, donc du circuit de mise en forme est définie par la constante de temps R143xC141. A titre d'exemple, cette constante de temps peut être de l'ordre de 1ms.

Il résulte de la description qui précède que le monostable 140 n'est déclenché que sur les fronts descendants du signal de sortie de la bascule 120 et que ces fronts descendants ne sont générés qu'en cas d'apparition d'une impulsion de polarité positive faisant suite à une impulsion de polarité négative aux bornes du capteur C.

L'apparition d'un seul parasite de polarité positive en entrée de la bascule 120 est sans effet sur le circuit de mise en forme. De même, l'apparition d'un seul parasite de polarité négative en entrée de la bascule 120 ne peut générer une impulsion en sortie du circuit de mise en forme.

Selon un mode de réalisation particulier conforme à la présente invention, mais bien entendu non limitatif, les composants du circuit de mise en forme représentés sur la figure 1 ont les valeurs suivantes :

- R111 : 220 Ω
- R112 : 15Ω
- R114 : 1KΩ
- R116 : 1KΩ
- R122 : 22KΩ
- R123 : 51KΩ
- R125 : 22KΩ
- R126 : 47KΩ
- R129 : 1M Ω
- R143 : 10KΩ
- R144 : 6,8K Ω
- R145 : 22K Ω
- C115 : 100nF
- C124 : 4,7nF
- C127 : 220nF
- C130 : 4,7nF
- C141 : 100nF
- D1 et D2 sont de type 1N4148
- le transistor T113 est de type BC327
- les amplificateurs opérationnels OP128 et OP146 sont de type LM2904

Bien entendu la présente invention n'est pas limitée au mode de réalisation qui vient d'être décrit mais s'étend à toutes variantes conformes à son esprit.

Le cas échéant, la résistance de polarisation R111 peut être remplacée par une diode Zener, telle que par exemple une diode BZX 55C de 2,4V. Le capteur C est ainsi alimenté par un générateur de courant constant. Cette disposition permet d'obtenir en sortie du capteur C, un signal de plus grande amplitude qu'avec un générateur de tension. Par ailleurs, on obtient ainsi une plus grande symétrie entre les alternances respectivement haute et basse issues du capteur.

Par ailleurs, le cas échéant une diode additionnelle peut être connectée en série de la résistance R129. Dans ce cas cette diode a son anode relié à la résistance R129, tandis que la cathode de la diode est reliée à l'entrée non inverseuse de OP128.

Cette diode additionnelle permet de ne pas faire varier le seuil de commutation bas de OP128, lorsque l'on règle le seuil de commutation haut de OP128.

Le seuil de commutation bas de OP128 est égal à la tension de repos du capteur C moins une tension U bas qui peut être aisément augmentée ou diminuée en modifiant la valeur de la résistance R123, puisque U bas est proportionnelle à R123.

De même le seuil de commutation haut de OP128 est égal à la tension de repos du capteur C plus une tension U haut qui peut être aisément augmentée ou diminuée en modifiant la valeur de la résistance R129, puisque U haut est inversement proportionnelle à la valeur de la résistance R129.

## Revendications

1. Dispositif de mise en forme d'un signal de capteur du type comprenant deux impulsions successives de polarités opposées, respectivement de première polarité, puis de deuxième polarité, caractérisé par le fait qu'il comprend :

    – un premier étage (120) de type bascule de Schmitt connecté en sortie du capteur (C) et conçu pour passer d'un état de repos à un second état lors de l'arrivée d'une impulsion de première polarité générant ainsi un premier front d'un premier sens puis pour passer du second état à l'état de repos lors de l'arrivée d'une impulsion de deuxième polarité générant ainsi un second front d'un second sens, opposé au premier, et

    – un second étage (140) de type monostable connecté en sortie du premier étage (120) et conçu pour être déclenché par les fronts de second sens issus du premier étage.

2. Dispositif selon la revendication 1, caractérisé par le fait que le premier étage (120) de type bascule de Schmitt comprend un amplificateur opérationnel (OP128) dont les deux entrées sont polarisées par des ponts diviseurs résistifs intercalés entre la sortie du capteur (C) et la masse du montage.

3. Dispositif selon la revendication 2, caractérisé par le fait qu'une diode (D121) est intercalée entre la sortie du capteur (C) et les ponts diviseurs résistifs (R122, R123 ; R125, R126).

4. Dispositif selon l'une des revendications 2 ou 3, caractérisé par le fait que les ponts diviseurs résistifs appliquent au repos un potentiel sur l'entrée inverseuse de l'amplificateur opérationnel (OP128) supérieur au potentiel appliqué sur son entrée non inverseuse.

5. Dispositif selon l'une des revendications 2 à 4, caractérisé par le fait que les ponts diviseurs résistifs comprennent des résistances (R122, R125) de même valeur entre la sortie du capteur (C) et les entrées respectivement associées de l'amplificateur opérationnel (OP128), la résistance (R123) reliée à la masse, du pont diviseur résistif associé à l'entrée inverseuse de l'amplificateur opérationnel (OP128) étant supérieure à la résistance (R126) reliée à la masse du pont diviseur résistif associé à son entrée non inverseuse.

6. Dispositif selon l'une des revendications 2 à 5, caractérisé par le fait qu'un condensateur (C127) est connecté en parallèle de la résistance (R126) reliant l'entrée non inverseuse de l'amplificateur opérationnel (OP128) à la masse.

7. Dispositif selon l'une des revendications 2 à 5, caractérisé par le fait que des condensateurs (C124, C127) sont connectés respectivement en parallèle des résistances (R123, R126) reliant les entrées de l'amplificateur opérationnel (OP128) à la masse, le condensateur associé à l'entrée non inverseuse étant supérieur au condensateur (C124) associé à l'entrée inverseuse.

8. Dispositif selon l'une des revendications 1 à 7, caractérisé par le fait qu'une contre-réaction est prévue entre la sortie et l'une des entrées de l'amplificateur opérationnel (OP128) formant la bascule de Schmitt (120).

9. Dispositif selon l'une des revendications 1 à 8, caractérisé par le fait qu'une contre-réaction formée d'une résistance (R129) connectée en parallèle d'un condensateur (C130) est prévue entre la sortie et l'entrée non inverseuse de l'amplificateur opérationnel (OP128) formant la bascule de Schmitt (120).

10. Dispositif selon l'une des revendications 1 à 8, caractérisé par le fait qu'une contre-réaction comprenant deux branches en parallèle est prévue entre la sortie et l'entrée non inverseuse de l'amplificateur opérationnel (OP128) formant la bascule de Schmitt (120) : une première branche comportant un condensateur (C130) et une seconde branche comportant une résistance (R129) connectée en série d'une diode.

11. Dispositif selon l'une des revendications 1 à 10, caractérisé par le fait que le monostable de sortie (140) comprend un amplificateur opérationnel (OP146).

12. Dispositif selon la revendication 11, caractérisé par le fait que l'une des entrées de l'amplificateur opérationnel (OP146) reçoit une tension de référence définie par un pont diviseur résistif (R144, R145) tandis que l'autre entrée de l'amplificateur opérationnel (OP146) est reliée à la sortie de la bascule de Schmitt (120).

13. Dispositif selon la revendication 12, caractérisé par le fait que ladite autre entrée est en outre reliée à une borne d'alimentation (+VCC) par l'intermédiaire d'une résistance (R143).

14. Dispositif selon l'une des revendications 12 ou 13, caractérisé par le fait que ladite autre entrée est en outre reliée à la borne d'alimentation (+VCC) par l'intermédiaire d'une diode (D142).

15. Dispositif selon l'une des revendications 12 à 14, caractérisé par le fait que ladite autre entrée de l'amplificateur opérationnel (OP146) est reliée à la sortie de la bascule de Schmitt (120) par l'intermédiaire d'un condensateur série (C141).

16. Dispositif selon l'une des revendications 12 à 15, caractérisé par le fait que ladite autre entrée est l'entrée inverseuse de l'amplificateur opérationnel (OP146).

17. Dispositif selon l'une des revendications 1 à 16, caractérisé par le fait qu'un filtre (C115, R116) est connecté en parallèle du capteur (C).

18. Dispositif selon l'une des revendications 1 à 17, caractérisé par le fait que le capteur est alimenté par une source de tension continue par l'intermédiaire d'un étage transistorisé (T113).

19. Dispositif selon l'une des revendications 1 à 18, caractérisé par le fait que le capteur (C) est un capteur de point mort haut de véhicule automobile.

## FIG.1

+ Vcc

$Z_{11}$

$T_{10}$

30

SORTIE

20

C

## FIG.2

+ Vcc

40

50

SORTIE

C

FIG_3

100

+ Vcc

110

R111   R112   120   C124   R123   D142   R143   R144   140

T113   R122   OP128   C141   OP146   SORTIE

D121

R125

R129

D121

C127   C130

R114

C   C115   R116   R126   R145

EP 0 449 723 A1

Office européen
des brevets

**RAPPORT DE RECHERCHE EUROPEENNE**

Numero de la demande

EP 91 40 0810

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | AU-A- 514 484 (CHRYSLER CORP.) <br> * Figures 1,2; page 4, ligne 12 - page 7, ligne 8 * <br> --- | 1,19 | H 03 K 5/19 <br> H 03 K 3/023 <br> F 02 P 7/06 |
| A | FR-A-2 213 689 (CHRYSLER CORP.) <br> * Figure 1; page 5, lignes 1-17 * <br> --- | 1,17,19 | |
| A | IBM TECHNICAL DISCLOSURE BULLETIN, vol. 20, no. 4; septembre 1977, pages 1479-1480, New York, US; J.C. MAILLET: "Data recovery circuit" <br> * Fig.; pages 1479-1480 * <br> --- | 1,2,8, 17 | |
| A | DE-A-2 656 141 (NISSAN MOTOR CO.) <br> * Figures 4,5,7,8; page 9, lignes 2-22; page 13, lignes 2-10 * <br> ----- | 1,19 | |
| | | | **DOMAINES TECHNIQUES RECHERCHES (Int. Cl.5)** <br><br> H 03 K <br> G 01 M <br> F 02 P <br> G 11 B |

Le présent rapport a été établi pour toutes les revendications

| Lieu de la recherche | Date d'achèvement de la recherche | Examinateur |
|---|---|---|
| LA HAYE | 03-07-1991 | FEUER F.S. |